# EUROPEAN PATENT APPLICATION

(11) **EP 4 571 815 A1**
(43) Date of publication of application: **18.06.2025**
(21) Application number: 23852406.0
(22) Date of filing: 28.07.2023
(51) Int. Cl.: H01L 21/205, H01L 21/02, H01L 21/20, H01L 27/12, H01L 29/06

(54) **METHOD FOR PRODUCING SILICON SUBSTRATE FOR QUANTUM COMPUTERS, SILICON SUBSTRATE FOR QUANTUM COMPUTERS, AND SEMICONDUCTOR DEVICE**

(30) Priority: 08.08.2022 JP 2022126471; 06.09.2022 JP 2022141365
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP); SUZUKI, Atsushi, Nishishirakawa-gun, Fukushima 961-8061 (JP); MATSUBARA, Toshiki, Nishishirakawa-gun, Fukushima 961-8061 (JP); ABE, Tatsuo, Nishishirakawa-gun, Fukushima 961-8061 (JP); SUZUKI, Katsuyoshi, Annaka-shi, Gunma 379-0196 (JP)
(74) Representative: Sonnenhauser, Thomas Martin
(86) International application number: PCT/JP2023/027757
(87) International publication number: WO 2024/034433

(57) **Abstract**

The present invention is a method for manufacturing a silicon substrate for a quantum computer, the method includes the steps of forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate, forming an oxygen (O) δ-doped layer by oxidizing a surface of the Si epitaxial layer, and forming a Si epitaxial layer by epitaxial growth using a Si source gas, in which a total content of ²⁸Si and ³⁰Si in a whole silicon contained in the silicon-based raw material gas is 99.9% or more, on the δ-doped layer. This provides the silicon substrate for a quantum computer capable of suppressing the effect of ²⁹Si to suppress the effect of a nuclear spin and a method for manufacturing such a substrate.

## Description

### TECHNICAL FIELD

The present invention relates to a method for manufacturing a silicon substrate for a quantum computer, a silicon substrate for a quantum computer, and a semiconductor apparatus.

### BACKGROUND ART

Quantum computers that utilize quantum effects such as superposition or entanglement have attracted attention as computers that can solve calculations which is unable to be solved within realistic time by conventional computers. Devices used for quantum computers are also mounted on semiconductor substrates such as silicon substrates.

While the devices used for quantum computers have several methods, major methods include a method to utilize the Josephson effect with superconductors as well as a method to convert the quantum effects into electric signals by using electron spins (ESR).

In the devices using the silicon substrates for utilizing electron spins, the quantum effects are read out by placing the electron spins in electromagnetic fields and irradiating the spins with microwave to sweep frequency to cause resonance (Patent Document 1).

### CITATION LIST

### PATENT LITERATURE

Patent Document 1: JP 2022-025657 A
Patent Document 2: JP 2021-111696 A

### SUMMARY OF INVENTION

### TECHNICAL PROBLEM

When utilizing an electron spin in this manner, presence of unwanted spin components in the vicinity splits electron spin energy due to the Zeeman effect, preventing the quantum effect from being used for calculations. Consequently, it is necessary to form a Si layer predominantly (rich) composed of ²⁸Si, while minimizing ²⁹Si that has a nuclear spin.

Thus, a silicon substrate is used in which a ²⁸Si epitaxial layer is formed using isotopically-enriched ²⁸SiH₄ gas. In addition, in order to have a single electron layer (when a plurality of electrons is present, the calculation becomes difficult due to spin interaction between the electrons), confinement of the electrons (single-electron transistor) is necessitated.

As structures for this purpose, a method in which a Fin structure is produced to confine the electron at a tip of the Fin, or an SOI (Silicon On Insulator) structure is often adopted. The Fin structure has an advantage that can be formed solely by silicon, but a treatment of a surface level of a silicon surface is difficult. On the other hand, an effect of an interface between the silicon and an oxide film is small in the SOI structure, but a method of forming an insulation layer is difficult. That is, even when ²⁸Si is oxidation-treated, diffusion of the silicon during the heat treatment causes an effect of ²⁹Si which has the nuclear spin.

Moreover, the diffusion of ²⁸Si is also generated in the same manner in the heat treatment during a formation of the SOI by conventional methods such as bonding and the like, thus an isotope effect of ²⁸Si cannot be fully utilized.

The present invention has been made to solve the above-described problem. An object of the present invention is to provide a silicon substrate for a quantum computer capable of suppressing the effect of ²⁹Si to suppress the effect of a nuclear spin and a method for manufacturing such a substrate.

### SOLUTION TO PROBLEM

The present invention has been made to achieve the above-described object. The present invention provides a method for manufacturing a silicon substrate for a quantum computer, the method comprising the steps of:
forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate;
forming an oxygen (O) δ-doped layer by oxidizing a surface of the Si epitaxial layer; and
forming a Si epitaxial layer by epitaxial growth using a Si source gas, in which a total content of ²⁸Si and ³⁰Si in a whole silicon contained in the silicon-based raw material gas is 99.9% or more, on the δ-doped layer.

According to such a method for manufacturing a silicon substrate for a quantum computer, the silicon substrate for a quantum computer capable of suppressing an effect of a nuclear spin can be manufactured and a silicon substrate, in which an isotope effect suitable for a quantum computer can be fully demonstrated, and a single-electron transistor can be easily formed, can be manufactured.

In this case, a monosilane gas can be used as the Si source gas in the method for manufacturing a silicon substrate for a quantum computer.

This enables the manufacture of the silicon substrate suitable for a quantum computer at a lower temperature.

In this case, the step of forming the oxygen (O) δ-doped layer and the step of forming the Si epitaxial layer on the δ-doped layer can be repeated to form a plurality of pairs of the δ-doped layers, and the Si epitaxial layers on the δ-doped layers in the method for manufacturing a silicon substrate for a quantum computer.

This enables the manufacture of the silicon substrate more suitable for a quantum computer.

In this case, a Si epitaxial layer of an outermost surface of the silicon substrate for a quantum computer can have a thickness greater than that of a Si epitaxial layer other than the Si epitaxial layer of the outermost surface layer in the method for manufacturing a silicon substrate for a quantum computer.

This enables the manufacture of the silicon substrate that is further suitable for a quantum computer.

In this case, a plurality of the δ-doped layers can be integrated to produce an SOI structure by heat-treating the silicon substrate for a quantum computer in the method for manufacturing a silicon substrate for a quantum computer.

This enables the manufacture of the silicon substrate having an SOI structure suitable for a quantum computer.

In this case, the silicon substrate can have a resistivity of 1000 Ω·cm or higher in the method for manufacturing a silicon substrate for a quantum computer.

This enables the manufacture of the silicon substrate for a quantum computer which is capable of stably extracting undistorted signals obtained by spin resonance.

In addition, the present invention provides a method for manufacturing a silicon substrate for a quantum computer, the method comprising the steps of:
forming a ²⁸Si epitaxial layer by epitaxial growth using a ²⁸Si source gas as a silicon-based raw material gas on a silicon substrate;
forming an oxygen (O) δ-doped layer by oxidizing a surface of the ²⁸Si epitaxial layer; and
forming a ²⁸Si epitaxial layer by epitaxial growth using a ²⁸Si source gas on the δ-doped layer.

According to such a method for manufacturing a silicon substrate for a quantum computer, the silicon substrate for a quantum computer capable of suppressing an effect of a nuclear spin can be manufactured, and a silicon substrate, in which an isotope effect suitable for a quantum computer can be fully demonstrated and a single-electron transistor can be easily formed, can be manufactured.

In this case, a ²⁸Si monosilane gas can be used as the ²⁸Si source gas in the method for manufacturing a silicon substrate for a quantum computer.

This enables the manufacture of the silicon substrate suitable for a quantum computer at a lower temperature.

In this case, the step of forming the oxygen (O) δ-doped layer and the step of forming the ²⁸Si epitaxial layer on the δ-doped layer can be repeated to form a plurality of pairs of the δ-doped layers, and the ²⁸Si epitaxial layers on the δ-doped layers in the method for manufacturing a silicon substrate for a quantum computer.

This enables the manufacture of the silicon substrate to be more suitable for a quantum computer.

In this case, a ²⁸Si epitaxial layer of an outermost surface of the silicon substrate for a quantum computer can have a thickness greater than that of a ²⁸Si epitaxial layer other than the ²⁸Si epitaxial layer of the outermost surface in the method for manufacturing a silicon substrate for a quantum computer.

This enables the manufacture of the silicon substrate that is further suitable for a quantum computer.

In this case, a plurality of the δ-doped layers can be integrated to produce an SOI structure by heat-treating the silicon substrate for a quantum computer in the method for manufacturing a silicon substrate for a quantum computer.

This enables the manufacture of a silicon substrate having an SOI structure suitable for a quantum computer.

In this case, the silicon substrate can have a resistivity of 1000 Ω·cm or higher in the method for manufacturing a silicon substrate for a quantum computer.

This enables the manufacture of the silicon substrate for a quantum computer which is capable of stably extracting undistorted signals obtained by spin resonance.

In addition, the present invention has been made to achieve the above-described object. The present invention provides a silicon substrate for a quantum computer comprising:
a silicon substrate;
a Si epitaxial layer, being an epitaxial layer on the silicon substrate, having a composition in which a total content of ²⁸Si and ³⁰Si in a whole silicon of the epitaxial layer is 99.9% or more;
a SiO₂ layer, being a SiO₂ layer on the Si epitaxial layer, having a composition in which a total content of ²⁸Si and ³⁰Si in a whole silicon of the SiO₂ layer is 99.9% or more; and
a Si epitaxial layer, being an epitaxial layer on the SiO₂ layer, having a composition in which a total content of ²⁸Si and ³⁰Si in a whole silicon of the epitaxial layer is 99.9% or more.

According to such a silicon substrate for a quantum computer, the substrate can be the silicon substrate for a quantum computer capable of suppressing an effect of a nuclear spin, as well as the silicon substrate in which an isotope effect suitable for a quantum computer can be fully demonstrated and a single-electron transistor can be easily formed.

In this case, the SiO₂ layer can be an oxygen (O) δ-doped layer in the silicon substrate for a quantum computer.

This results in the silicon substrate having the δ-doped layer suitable for a quantum computer.

In this case, the SiO₂ layer can be a buried oxide film (BOX) layer in an SOI structure in the silicon substrate for a quantum computer.

This results in the silicon substrate having the SOI structure suitable for a quantum computer.

In this case, an apparatus can be a semiconductor apparatus comprising a device on a silicon substrate, the substrate being for a quantum computer.

This results in the semiconductor apparatus in which an effect of a nuclear spin is suppressed.

In addition, the present invention provides a silicon substrate for a quantum computer comprising:
a silicon substrate;
a ²⁸Si epitaxial layer on the silicon substrate;
a ²⁸SiO₂ layer on the ²⁸Si epitaxial layer; and
a ²⁸Si epitaxial layer on the ²⁸SiO₂ layer.

According to such a silicon substrate for a quantum computer, the substrate can be the silicon substrate for a quantum computer capable of suppressing an effect of a nuclear spin, as well as the silicon substrate in which an isotope effect suitable for a quantum computer can be fully demonstrated and a single-electron transistor can be easily formed.

In this case, the ²⁸SiO₂ layer can be an oxygen (O) δ-doped layer in the silicon substrate for a quantum computer.

This results in the silicon substrate having the δ-doped layer suitable for a quantum computer.

In this case, the ²⁸SiO₂ layer can be a buried oxide film (BOX) layer in an SOI structure in the silicon substrate for a quantum computer.

This results in the silicon substrate having the SOI structure suitable for a quantum computer.

In this case, an apparatus can be a semiconductor apparatus comprising a device on a silicon substrate, the substrate being for a quantum computer.

This results in the semiconductor apparatus in which an effect of a nuclear spin is suppressed.

### ADVANTAGEOUS EFFECTS OF INVENTION

As described above, according to the inventive method for manufacturing a silicon substrate for a quantum computer, the silicon substrate for a quantum computer capable of suppressing an effect of a nuclear spin can be manufactured, and a silicon substrate, in which an isotope effect suitable for a quantum computer can be fully demonstrated and a single-electron transistor can be easily formed, can be manufactured. According to the inventive silicon substrate for a quantum computer, the substrate can be the silicon substrate for a quantum computer capable of suppressing an effect of a nuclear spin, as well as the silicon substrate, in which an isotope effect suitable for a quantum computer can be fully demonstrated and a single-electron transistor, can be easily formed.

### BRIEF DESCRIPTION OF DRAWINGS

FIG. 1 shows a schematic view describing an example of a structure of a silicon substrate for a quantum computer according to the present invention.
FIG. 2 shows a schematic view describing another example of a structure of a silicon substrate for a quantum computer according to the present invention.
FIG. 3 shows a schematic view describing a flow of a method for manufacturing a silicon substrate for a quantum computer according to the present invention.

### DESCRIPTION OF EMBODIMENTS

Hereinafter, the present invention will be described in detail. However, the present invention is not limited thereto.

As described above, a silicon substrate for a quantum computer capable of suppressing the effect of ²⁹Si to suppress the effect of a nuclear spin and a method for manufacturing such a substrate has been required.

To solve the above problem, the present inventors have earnestly studied and found a method for manufacturing a silicon substrate for a quantum computer including the steps of forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate, forming an oxygen (O) δ-doped layer by oxidizing a surface of the Si epitaxial layer, and forming a Si epitaxial layer by epitaxial growth using a Si source gas, in which a total content of ²⁸Si and ³⁰Si in a whole silicon contained in the silicon-based raw material gas is 99.9% or more, on the δ-doped layer. Through this method, the silicon substrate for a quantum computer capable of suppressing an effect of a nuclear spin can be manufactured, and a silicon substrate, in which an isotope effect suitable for a quantum computer can be fully demonstrated and a single-electron transistor can be easily formed, can be manufactured. Based on this finding, the present invention has been completed.

In addition, the present inventors have found a method for manufacturing a silicon substrate for a quantum computer including the steps of forming a ²⁸Si epitaxial layer by epitaxial growth using a ²⁸Si source gas as a silicon-based raw material gas on a silicon substrate, forming an oxygen (O) δ-doped layer by oxidizing a surface of the ²⁸Si epitaxial layer, and forming a ²⁸Si epitaxial layer by epitaxial growth using a ²⁸Si source gas on the δ-doped layer. Through this method, the silicon substrate for a quantum computer capable of suppressing an effect of a nuclear spin can be manufactured, and a silicon substrate, in which an isotope effect suitable for a quantum computer can be fully demonstrated, and a single-electron transistor can be easily formed, can be manufactured. Based on this finding, the present invention has been completed.

In addition, the present inventors have earnestly studied the above problem and found a silicon substrate for a quantum computer including a silicon substrate, a Si epitaxial layer, being an epitaxial layer on the silicon substrate, having a composition with which a total content of ²⁸Si and ³⁰Si in a whole silicon of the epitaxial layer is 99.9% or more, a SiO₂ layer, being a SiO₂ layer on the Si epitaxial layer, having a composition in which a total content of ²⁸Si and ³⁰Si in a whole silicon of the SiO₂ layer is 99.9% or more, and a Si epitaxial layer, being an epitaxial layer on the SiO₂ layer, having a composition in which a total content of ²⁸Si and ³⁰Si in a whole silicon of the epitaxial layer is 99.9% or more. Through this substrate, the substrate can be the silicon substrate for a quantum computer capable of suppressing an effect of a nuclear spin, as well as the silicon substrate in which an isotope effect suitable for a quantum computer can be fully demonstrated and a single-electron transistor can be easily formed. Based on this finding, the present invention has been completed.

In addition, the present inventors have found a silicon substrate for a quantum computer including a silicon substrate, a ²⁸Si epitaxial layer on the silicon substrate, a ²⁸SiO₂ layer on the ²⁸Si epitaxial layer, and a ²⁸Si epitaxial layer on the ²⁸SiO₂ layer. Through this substrate, the substrate can be the silicon substrate for a quantum computer capable of suppressing an effect of a nuclear spin, as well as the silicon substrate in which an isotope effect suitable for a quantum computer can be fully demonstrated and a single-electron transistor can be easily formed. Based on this finding, the present invention has been completed.

Hereinafter, the description will be given, referring to the drawings.

Hereinafter, the term "²⁸Si" is used as an example to describe a definition of terms; however, the same expressions may be used for other isotopes (such as ³⁰Si).

In the present description, "²⁸Si source gas", being the silicon-based raw material gas, indicates a gas that has a composition in which a content of ²⁸Si in a whole silicon in a silicon-containing gas is 99.9% or more. "²⁸Si monosilane gas" (may also be expressed as "²⁸SiH₄") indicates a monosilane gas that has a composition in which a content of ²⁸Si in a whole silicon in the monosilane (SiH₄) gas is 99.9% or more. The silicon has three stable isotopes, i.e., ²⁸Si, ²⁹Si, ³⁰Si. Although a natural abundance thereof is 92.23%, 4.67%, and 3.1%, respectively, for example, the ²⁸Si source gas can be produced by centrifugation of the silicon-containing gas (silane-based gas) composed of natural Si isotope composition. The ³⁰Si source gas or "the Si source gas having the total content of ²⁸Si and ³⁰Si in a whole silicon contained in the silicon-based raw material gas is 99.9% or more" can also be produced in the same manner.

In the present description, the "²⁸Si epitaxial layer" indicates an epitaxial layer that has a composition in which a content of ²⁸Si in a whole silicon in the epitaxial layer is 99.9% or more. For example, this layer can be obtained by epitaxial growth using the ²⁸Si source gas.

In the present description, "²⁸SiO₂" indicates SiO₂ that has a composition in which a content of ²⁸Si in a whole silicon in SiO₂ is 99.9% or more. For example, this can be obtained by oxidizing the ²⁸Si epitaxial layer.

In the present description, "δ-doped layer" is a layer in which an element different from a base material is introduced therein at a level of approximately a single atomic layer. An oxygen (O) δ-doped layer includes, for example, a case where oxygen of less than the single atomic layer (1.36×10¹⁵ atoms/cm²) is introduced on the silicon substrate. Note that the δ-doping method includes methods such as a method disclosed in Patent Document 2.

### [Silicon Substrate for Quantum Computer]

### (First Embodiment)

The present inventors have earnestly studied the above problem and, as a result, found a silicon substrate for a quantum computer including a silicon substrate, a Si epitaxial layer, being an epitaxial layer on the silicon substrate, having a composition in which a total content of ²⁸Si and ³⁰Si in a whole silicon in the epitaxial layer is 99.9% or more, a SiO₂ layer, being a SiO₂ layer on the Si epitaxial layer, having a composition in which a total content of ²⁸Si and ³⁰Si in a whole silicon in the SiO₂ layer is 99.9% or more, and a Si epitaxial layer, being an epitaxial layer on the SiO₂ layer, having a composition in which a total content of ²⁸Si and ³⁰Si in a whole silicon in the epitaxial layer is 99.9% or more. Through this, it is found such a substrate can be the silicon substrate for a quantum computer being capable of suppressing the effect of ²⁹Si, thereby suppressing the effect of a nuclear spin.

The Si epitaxial layer in the inventive silicon substrate for a quantum computer only needs to have a composition in which a total content of ²⁸Si and ³⁰Si is 99.9% or more in the whole silicon contained in the epitaxial layer, and is not necessarily required to contain both ²⁸Si and ³⁰Si. The case in which the content of ²⁸Si in a whole silicon in the epitaxial layer is 99.9% or more, or a case where the content of ³⁰Si is 99.9% or more may be sufficient.

In this case, the SiO₂ layer is preferably the oxygen (O) δ-doped layer. Such a silicon substrate for a quantum computer serves as a silicon substrate having the δ-doped layer suitable for a quantum computer.

Moreover, the SiO₂ layer is preferably a buried oxide film (BOX) layer in an SOI structure. Such a silicon substrate for a quantum computer serves as a silicon substrate having the SOI structure suitable for a quantum computer.

Furthermore, the above silicon substrate for a quantum computer is preferably provided with a device thereon. Such a semiconductor apparatus serves as a semiconductor apparatus where the effect of the nuclear spin is suppressed.

Regarding more detailed embodiment, the description will be given in the following second embodiment which corresponds to the silicon substrate for a quantum computer according to the first embodiment in which the composition of the content of ²⁸Si in the whole silicon in the epitaxial layer is set to 99.9% or more.

### (Second Embodiment)

In addition, the present inventors found a silicon substrate for a quantum computer including a silicon substrate, a ²⁸Si epitaxial layer on the silicon substrate, a ²⁸SiO₂ layer on the ²⁸Si epitaxial layer, and a ²⁸Si epitaxial layer on the ²⁸SiO₂ layer, and this silicon substrate can suppress an effect of ²⁹Si and thus an effect of a nuclear spin. As described above, the silicon substrate for a quantum computer according to the second embodiment of the present invention corresponds to the silicon substrate for a quantum computer, according to the above first embodiment, in which a composition of a content of ²⁸Si in a whole silicon in an epitaxial layer is set to 99.9% or more.

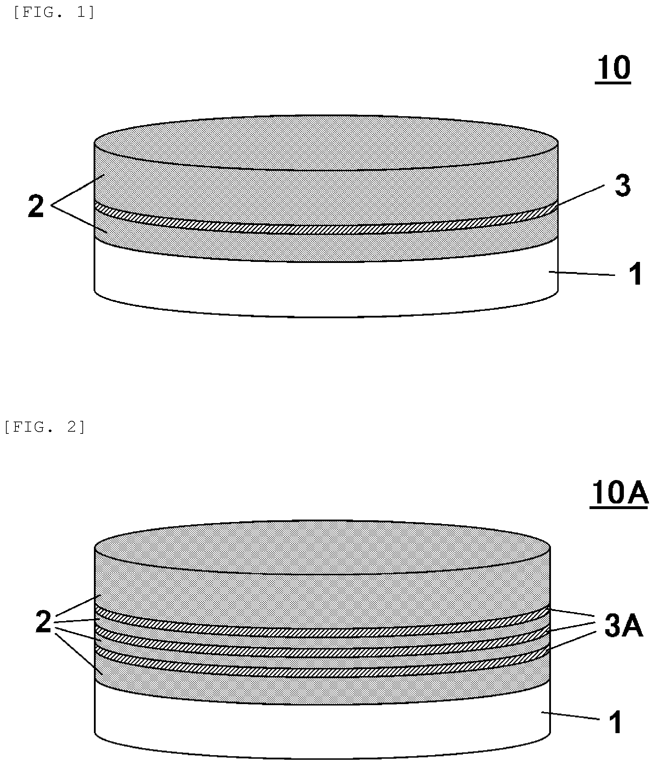

FIG. 1 shows an example of a structure of the inventive silicon substrate for a quantum computer. The silicon substrate for a quantum computer according to the second embodiment includes a silicon substrate 1, a ²⁸Si epitaxial layer 2 on the silicon substrate 1, a ²⁸SiO₂ layer 3 on the ²⁸Si epitaxial layer 2, and the ²⁸Si epitaxial layer 2 on the ²⁸SiO₂ layer 3.

The ²⁸SiO₂ layer 3 in the silicon substrate for a quantum computer shown in FIG. 1 can be an oxygen (O) δ-doped layer. FIG. 2 shows an example in which a plurality of layers of oxygen (O) δ-doped layers 3A (a plurality of pairs of the oxygen (O) δ-doped layers 3A and adjacent the ²⁸Si epitaxial layers 2), but the oxygen (O) δ-doped layer may be single layer (one layer) as in the ²⁸SiO₂ layer 3 in FIG. 1.

Moreover, the ²⁸SiO₂ layer 3 in the silicon substrate for a quantum computer shown in FIG. 1 can be a buried oxide film (BOX) layer in an SOI structure. In this case, the buried oxide film (BOX) layer (²⁸SiO₂ layer) can have a film thickness of approximately 0.01 to 1 µm.

The silicon substrate 1 used for the inventive silicon substrate for a quantum computer will be described. The silicon substrate 1 is not particularly limited as long as the ²⁸Si epitaxial layer can be deposited on this substrate. A diameter, thickness, dopant, etc., are not particularly limited. In the quantum computer, a microwave and the like are used to read out a spin state of electrons, etc., which exhibit quantized behavior. Consequently, a high-resistance substrate is preferably used to reduce signal distortion in a transmission path. In particular, the substrate having a resistivity of about 1000 Ω·cm or higher is preferable. This enables the silicon substrate for a quantum computer to stably extract undistorted signal obtained through spin resonance. The upper limit of the resistivity of the silicon substrate is not particularly limited but can, for example, be 100000 Ω·cm or lower.

A semiconductor apparatus having a device provided on the inventive silicon substrate for a quantum computer described above becomes the semiconductor apparatus in which the effect of the nuclear spin is suppressed.

### [Method for Manufacturing Silicon Substrate for Quantum Computer]

### (Third Embodiment)

Next, a method for manufacturing a silicon substrate for a quantum computer, which is the third embodiment of the present invention, will be described. The inventive method for manufacturing a silicon substrate for a quantum computer includes the steps of forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate, forming an oxygen (O) δ-doped layer by oxidizing a surface of the Si epitaxial layer, and forming a Si epitaxial layer by epitaxial growth using a Si source gas, in which a total content of ²⁸Si and ³⁰Si in a whole silicon contained in the silicon-based raw material gas is 99.9% or more, on the δ-doped layer.

In a method for manufacturing a silicon substrate for a quantum computer according to the third embodiment of the present invention, the Si source gas in which a total content of ²⁸Si and ³⁰Si in a whole silicon contained in a silicon-based raw material gas is 99.9% or more is sufficient as a silicon-based raw material gas, not necessarily required to contain both ²⁸Si and ³⁰Si. This includes a case where the content of ²⁸Si in a whole silicon contained in a silicon-based raw material gas is 99.9% or more, or a case where the content of ³⁰Si is 99.9% or more.

A monosilane gas is preferably used as the Si source gas. This enables the manufacture of the silicon substrate suitable for a quantum computer at a lower temperature.

It is preferred that the step of forming the oxygen (O) δ-doped layer and the step of forming the Si epitaxial layer on the δ-doped layer are repeated to form a plurality of pairs of the δ-doped layers, and the Si epitaxial layers on the δ-doped layers. This enables the manufacture of the silicon substrate to be more suitable for a quantum computer.

Moreover, it is preferred that a Si epitaxial layer of an outermost surface of the silicon substrate for a quantum computer has a thickness greater than that of a Si epitaxial layer other than the Si epitaxial layer of the outermost surface layer. This enables the manufacture of the silicon substrate that is further suitable for a quantum computer.

In this case, the silicon substrate is preferred to have a resistivity of 1000 Ω·cm or higher. This enables the manufacture of the silicon substrate for a quantum computer capable of stably extracting undistorted signals obtained through spin resonance. The upper limit of the resistivity of the silicon substrate is not particularly limited but can, for example, be 100000 Ω·cm or lower.

Regarding more detailed embodiment, the description will be given in the following fourth embodiment which corresponds to the method for manufacturing the silicon substrate for a quantum computer according to the third embodiment in which the composition of the content of ²⁸Si in the whole silicon contained in a silicon-based raw material gas is set to 99.9% or more.

### (Fourth Embodiment)

Moreover, a method for manufacturing a silicon substrate for a quantum computer according to the fourth embodiment of the present invention includes the steps of forming a ²⁸Si epitaxial layer by epitaxial growth using a ²⁸Si source gas as a silicon-based raw material gas on a silicon substrate, forming an oxygen (O) δ-doped layer by oxidizing a surface of the ²⁸Si epitaxial layer, and forming a ²⁸Si epitaxial layer by epitaxial growth using the ²⁸Si source gas on the δ-doped layer. As described above, the method for manufacturing the silicon substrate for a quantum computer according to the fourth embodiment of the present invention corresponds to the method for the silicon substrate for a quantum computer according to the above third embodiment in which a composition of content of ²⁸Si in a whole silicon contained in a silicon-based raw material gas is set to 99.9% or more. Hereinafter, the description will be given in detail.

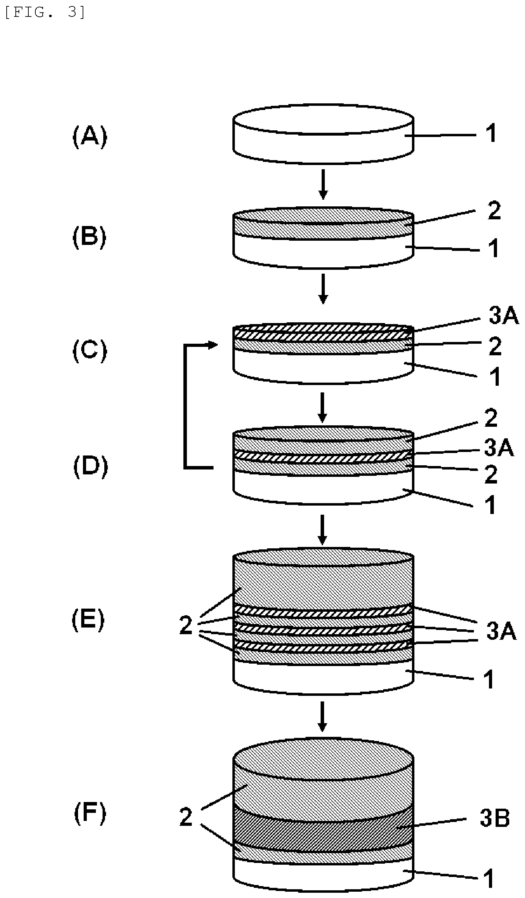

First, a silicon substrate 1 is provided as shown in FIG. 3(A).

Next, as shown in FIG. 3(B), the silicon substrate 1 is epitaxially grown (deposited) to form a ²⁸Si epitaxial layer 2. In this case, a CVD method can form the epitaxial layer with better crystallinity. In the epitaxial growth, for example, the ²⁸Si source gas obtained by isotopic enrichment is used as the silicon-based raw material gas. As the ²⁸Si source gas, it is particularly preferable to use a ²⁸Si monosilane gas (²⁸SiH₄). This enables epitaxial growth to be performed at a lower temperature.

Moreover, a thickness of the ²⁸Si epitaxial layer 2 at this time is not particularly limited, but a thickness having about 0.01 to 1 µm is sufficient. As clear from an example such as NMR of Si, this is reasonable when considering that an interaction between an electron spin and a nuclear spin, which is the strongest between adjacent atoms, and an effect thereof is diminished as separating the atoms by a few atoms.

Then as shown in FIG. 3(C), a ²⁸SiO₂ layer which is an oxide film for electron confinement is formed. In an example of FIG. 3, an oxygen (O) δ-doped layer 3A is formed using an oxygen (O) δ-doped method.

By using the δ-doped method to oxidize a surface of the ²⁸Si epitaxial layer and then form the oxygen (O) δ-doped layer 3A, it becomes possible to convert the silicon which is an insulating film into silicon oxide (²⁸SiO₂) which is unaffected from the nuclear spin, thereby avoiding the effect of the interaction between the electron spin and the nuclear spin.

Next, as shown in FIG. 3(D), the ²⁸Si epitaxial layer 2 is deposited on this δ-doped layer. As in a case of the ²⁸Si epitaxial layer 2 at the first layer, as described above, the CVD method can form the epitaxial layer with better crystallinity. The ²⁸Si source gas such as isotopically enriched ²⁸SiH₄ is used as a raw material gas. Moreover, a thickness of the epitaxial layer at this time is not required to be as thick as that of the ²⁸Si epitaxial layer 2 at the first layer and can be adjusted as appropriate to enable electron confinement. For example, the thickness thereof can be about 0.001 to 0.5 µm.

Although a device can be produced using a structure as is, the insulation layer formed up to this step is, as referred to as δ-doped, only oxygen inserted at an atomic level, and thus the insulation thereof may not be sufficient. Therefore, it is also preferable to repeat the step for forming the oxygen (O) δ-doped layer 3A in FIG. 3(C) and the step of forming the ²⁸Si epitaxial layer 2 on the δ-doped layer in FIG. 3(D) to form a plurality of pairs of the oxygen (O) δ-doped layers 3A and the ²⁸Si epitaxial layers on the δ-doped layers as shown in FIG. 3(E). This makes the silicon substrate more suitable for a quantum computer.

As shown in FIG. 3(F), it is also possible to oxidize and integrate a plurality of δ-doped layers by subsequent heat treatment, thereby forming a thick insulation layer. The resulting thick insulation layer can form an SOI structure that can function as a buried oxide film (BOX) layer 3B. This makes the silicon substrate more suitable for a quantum computer.

The number of stacks of the oxygen (O) δ-doped layers 3A and the ²⁸Si epitaxial layers 2 on the δ-doped layers can be adjusted as appropriate according to the characteristics and design of the device. Moreover, when integrating a plurality of δ-doped layers by oxidation, it is preferable to make the thickness of the ²⁸Si epitaxial layer 2 of an outermost layer greater than the thickness of the ²⁸Si epitaxial layer other than the ²⁸Si epitaxial layer of the outermost layer. For example, the thickness can be about 0.002 to 1 µm. In this way, even when the oxidation is performed, the ²⁸Si epitaxial layer 2 of the outermost layer is not eliminated.

By using the ²⁸Si-rich silicon layer (²⁸Si epitaxial layer), the ²⁸Si-rich oxide film (²⁸SiO₂ layer) can also be formed in the insulation layer.

### EXAMPLE

Hereinafter, the present invention will be specifically described with reference to Example. However, the present invention is not limited thereto.

### (Example)

A boron-doped silicon substrate having a diameter of 300 mm (resistivity: 1000 Ω·cm) was provided, ²⁸SiH₄ (isotope 99.94%) was used as a raw material, and a silicon epitaxial growth was performed. The film was grown to a thickness of 1 µm under reduced pressure condition of 100 Torr (13332 Pa) at a temperature of 850°C. Subsequently, a 2-hour left-in-atmosphere was performed to form a native oxide film composed of ²⁸SiO₂ (oxygen δ-doping), and a silicon epitaxial layer was formed again to a thickness of 3 nm, using ²⁸SiH₄ (isotope 99.94%) as the raw material, under reduced pressure condition of 100 Torr (13332 Pa) at the temperature of 850°C. Furthermore, a 2-hour left-in-atmosphere was performed to form the native oxide film composed of ²⁸SiO₂ (oxygen δ-doping). Thereafter, the formations of the silicon epitaxial layers to a thickness of 3 nm were repeated four times, using ²⁸SiH₄ (isotope 99.94%) as the raw material, under reduced pressure condition of 100 Torr (13332 Pa) at the temperature of 850°C. Finally, the silicon epitaxial layer was formed to a thickness of 100 nm, using ²⁸SiH₄ (isotope 99.94%) as the raw material, under reduced pressure condition of 100 Torr (13332 Pa) at the temperature of 850°C. Heat treatment was then performed at 800°C for 10 minutes, oxidizing the oxygen δ-doped layer to form a single oxide film (buried oxide film (BOX) layer), and then an SOI substrate having the ²⁸Si epitaxial layer as a top layer was produced.

As described above, according to Example of the present invention, the silicon substrate was successfully obtained in which the substrate was the silicon substrate for a quantum computer capable of suppressing an effect of a nuclear spin, as well as the silicon substrate in which an isotope effect suitable for a quantum computer was fully demonstrated and a single-electron transistor was easily formed.

The present description includes the following embodiments.
[A]: A method for manufacturing a silicon substrate for a quantum computer, the method comprising the steps of:
   forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate;
   forming an oxygen (O) δ-doped layer by oxidizing a surface of the Si epitaxial layer; and
   forming a Si epitaxial layer by epitaxial growth using a Si source gas, in which a total content of ²⁸Si and ³⁰Si in a whole silicon contained in the silicon-based raw material gas is 99.9% or more, on the δ-doped layer.
[B]: The method for manufacturing a silicon substrate for a quantum computer according to the above [A], wherein
   a monosilane gas is used as the Si source gas.
[C]: The method for manufacturing a silicon substrate for a quantum computer according to the above [A] or [B], wherein
   the step of forming the oxygen (O) δ-doped layer and the step of forming the Si epitaxial layer on the δ-doped layer are repeated to form a plurality of pairs of the δ-doped layers, and the Si epitaxial layers on the δ-doped layers.
[D]: The method for manufacturing a silicon substrate for a quantum computer according to the above [C], wherein
   a Si epitaxial layer of an outermost surface of the silicon substrate for a quantum computer has a thickness greater than that of a Si epitaxial layer other than the Si epitaxial layer of the outermost surface layer.
[E]: The method for manufacturing a silicon substrate for a quantum computer according to the above [D], wherein
   a plurality of the δ-doped layers is integrated to produce an SOI structure by heat-treating the silicon substrate for a quantum computer.
   [1]: A method for manufacturing a silicon substrate for a quantum computer, the method comprising the steps of:
      forming a ²⁸Si epitaxial layer by epitaxial growth using a ²⁸Si source gas as a silicon-based raw material gas on a silicon substrate;
      forming an oxygen (O) δ-doped layer by oxidizing a surface of the ²⁸Si epitaxial layer; and
      forming a ²⁸Si epitaxial layer by epitaxial growth using a ²⁸Si source gas on the δ-doped layer.
   [2]: The method for manufacturing a silicon substrate for a quantum computer according to the above [1], wherein
      a ²⁸Si monosilane gas is used as the ²⁸Si source gas.
   [3]: The method for manufacturing a silicon substrate for a quantum computer according to the above [1] or [2], wherein
      the step of forming the oxygen (O) δ-doped layer and the step of forming the ²⁸Si epitaxial layer on the δ-doped layer are repeated to form a plurality of pairs of the δ-doped layers, and the ²⁸Si epitaxial layers on the δ-doped layers.
   [4]: The method for manufacturing a silicon substrate for a quantum computer according to the above [3], wherein
      a ²⁸Si epitaxial layer of an outermost surface of the silicon substrate for a quantum computer has a thickness greater than that of a ²⁸Si epitaxial layer other than the ²⁸Si epitaxial layer of the outermost surface.
   [5]: The method for manufacturing a silicon substrate for a quantum computer according to the above [4], wherein
      a plurality of the δ-doped layers is integrated to produce an SOI structure by heat-treating the silicon substrate for a quantum computer.
   [6]: The method for manufacturing a silicon substrate for a quantum computer according to the above [A], [B], [C], [D], [E], [1], [2], [3], [4], or [5], wherein
      the silicon substrate has a resistivity of 1000 Ω·cm or higher.
[F]: A silicon substrate for a quantum computer comprising:
   a silicon substrate;
   a Si epitaxial layer, being an epitaxial layer on the silicon substrate, having a composition in which a total content of ²⁸Si and ³⁰Si in a whole silicon of the epitaxial layer is 99.9% or more;
   a SiO₂ layer, being a SiO₂ layer on the Si epitaxial layer, having a composition in which a total content of ²⁸Si and ³⁰Si in a whole silicon of the SiO₂ layer is 99.9% or more; and
   a Si epitaxial layer, being an epitaxial layer on the SiO₂ layer, having a composition in which a total content of ²⁸Si and ³⁰Si in a whole silicon of the epitaxial layer is 99.9% or more.
[G]: The silicon substrate for a quantum computer according to the above [F], wherein
   the SiO₂ layer is an oxygen (O) δ-doped layer.
[H]: The silicon substrate for a quantum computer according to the above [F], wherein
   the SiO₂ layer is a buried oxide film (BOX) layer in an SOI structure.
   [7]: A silicon substrate for a quantum computer comprising:
      a silicon substrate;
      a ²⁸Si epitaxial layer on the silicon substrate;
      a ²⁸SiO₂ layer on the ²⁸Si epitaxial layer; and
      a ²⁸Si epitaxial layer on the ²⁸SiO₂ layer.
   [8]: The silicon substrate for a quantum computer according to the above [7], wherein
      the ²⁸SiO₂ layer is an oxygen (O) δ-doped layer.
   [9]: The silicon substrate for a quantum computer according to the above [7], wherein
      the ²⁸SiO₂ layer is a buried oxide film (BOX) layer in an SOI structure.
   [10]: A semiconductor apparatus comprising a device on a silicon substrate, the substrate being for a quantum computer according to the above [F], [G], [H], [7], [8], or [9].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a silicon substrate for a quantum computer, the method comprising the steps of:
forming a Si epitaxial layer by epitaxial growth using a Si source gas as a silicon-based raw material gas, in which a total content of ²⁸Si and ³⁰Si in a whole silicon contained in the silicon-based raw material gas is 99.9% or more, on a silicon substrate;
forming an oxygen (O) δ-doped layer by oxidizing a surface of the Si epitaxial layer; and
forming a Si epitaxial layer by epitaxial growth using a Si source gas, in which a total content of ²⁸Si and ³⁰Si in a whole silicon contained in the silicon-based raw material gas is 99.9% or more, on the δ-doped layer.

2. The method for manufacturing a silicon substrate for a quantum computer according to claim 1, wherein
a monosilane gas is used as the Si source gas.

3. The method for manufacturing a silicon substrate for a quantum computer according to claim 1, wherein
the step of forming the oxygen (O) δ-doped layer and the step of forming the Si epitaxial layer on the δ-doped layer are repeated to form a plurality of pairs of the δ-doped layers, and the Si epitaxial layers on the δ-doped layers.

4. The method for manufacturing a silicon substrate for a quantum computer according to claim 3, wherein
a Si epitaxial layer of an outermost surface of the silicon substrate for a quantum computer has a thickness greater than that of a Si epitaxial layer other than the Si epitaxial layer of the outermost surface layer.

5. The method for manufacturing a silicon substrate for a quantum computer according to claim 4, wherein
a plurality of the δ-doped layers is integrated to produce an SOI structure by heat-treating the silicon substrate for a quantum computer.

6. A method for manufacturing a silicon substrate for a quantum computer, the method comprising the steps of:
forming a ²⁸Si epitaxial layer by epitaxial growth using a ²⁸Si source gas as a silicon-based raw material gas on a silicon substrate;
forming an oxygen (O) δ-doped layer by oxidizing a surface of the ²⁸Si epitaxial layer; and
forming a ²⁸Si epitaxial layer by epitaxial growth using a ²⁸Si source gas on the δ-doped layer.

7. The method for manufacturing a silicon substrate for a quantum computer according to claim 6, wherein
a ²⁸Si monosilane gas is used as the ²⁸Si source gas.

8. The method for manufacturing a silicon substrate for a quantum computer according to claim 6, wherein
the step of forming the oxygen (O) δ-doped layer and the step of forming the ²⁸Si epitaxial layer on the δ-doped layer are repeated to form a plurality of pairs of the δ-doped layers, and the ²⁸Si epitaxial layers on the δ-doped layers.

9. The method for manufacturing a silicon substrate for a quantum computer according to claim 8, wherein
a ²⁸Si epitaxial layer of an outermost surface of the silicon substrate for a quantum computer has a thickness greater than that of a ²⁸Si epitaxial layer other than the ²⁸Si epitaxial layer of the outermost surface.

10. The method for manufacturing a silicon substrate for a quantum computer according to claim 9, wherein
a plurality of the δ-doped layers is integrated to produce an SOI structure by heat-treating the silicon substrate for a quantum computer.

11. The method for manufacturing a silicon substrate for a quantum computer according to any one of claims 1 to 10, wherein
the silicon substrate has a resistivity of 1000 Ω·cm or higher.

12. A silicon substrate for a quantum computer comprising:
a silicon substrate;
a Si epitaxial layer, being an epitaxial layer on the silicon substrate, having a composition in which a total content of ²⁸Si and ³⁰Si in a whole silicon of the epitaxial layer is 99.9% or more;
a SiO₂ layer, being a SiO₂ layer on the Si epitaxial layer, having a composition in which a total content of ²⁸Si and ³⁰Si in a whole silicon of the SiO₂ layer is 99.9% or more; and
a Si epitaxial layer, being an epitaxial layer on the SiO₂ layer, having a composition in which a total content of ²⁸Si and ³⁰Si in a whole silicon of the epitaxial layer is 99.9% or more.

13. The silicon substrate for a quantum computer according to claim 12, wherein
the SiO₂ layer is an oxygen (O) δ-doped layer.

14. The silicon substrate for a quantum computer according to claim 12, wherein
the SiO₂ layer is a buried oxide film (BOX) layer in an SOI structure.

15. A silicon substrate for a quantum computer comprising:
a silicon substrate;
a ²⁸Si epitaxial layer on the silicon substrate;
a ²⁸SiO₂ layer on the ²⁸Si epitaxial layer; and
a ²⁸Si epitaxial layer on the ²⁸SiO₂ layer.

16. The silicon substrate for a quantum computer according to claim 15, wherein
the ²⁸SiO₂ layer is an oxygen (O) δ-doped layer.

17. The silicon substrate for a quantum computer according to claim 15, wherein
the ²⁸SiO₂ layer is a buried oxide film (BOX) layer in an SOI structure.

18. A semiconductor apparatus comprising a device on a silicon substrate, the substrate being for a quantum computer according to any one of claims 12 to 17.
